# EUROPEAN PATENT APPLICATION

(11) **EP 2 455 511 A1**
(43) Date of publication of application: **23.05.2012**
(21) Application number: 10799713.2
(22) Date of filing: 24.06.2010
(51) Int. Cl.: C23C 16/27, C23C 16/02, C23C 16/42, C23C 16/515

(54) **METHOD FOR PRODUCING DIAMOND-LIKE CARBON FILM BODY.**

(30) Priority: 13.07.2009 JP 2009164431
(71) Applicant: NGK Insulators, Ltd., Nagoya-shi, Aichi 467-8530 (JP)
(72) Inventor: SAITO Takao, Nagoya-shi Aichi 467-8530 (JP); TERAZAWA Tatsuya, Nagoya-shi Aichi 467-8530 (JP)
(74) Representative: TBK
(86) International application number: PCT/JP2010/060742
(87) International publication number: WO 2011/007653

(57) **Abstract**

Provided is a method of manufacturing a DLC film formed body in which peeling-off of a DLC film is suppressed. In manufacturing a DLC film formed body having a film hardness of 10 GPa or more, prior to the formation of the DLC film, a surface of a base is pretreated with a discharge plasma and a silicon carbide film being an interlayer is formed on the surface of the base. The surface of the base is pretreated by supplying an inside of the chamber with a gas mixture obtained by mixing 1 part by volume or more and 10 parts by volume or less of argon gas into 100 parts by volume of helium gas while adjusting a pressure inside of the chamber in which the base is housed to 20 hPa or higher and an atmospheric pressure or lower, and generating a discharge plasma in the mixed.

## Description

### Technical Field

The present invention relates to a method of manufacturing a diamond-like carbon film formed body in which a diamond-like carbon film having a film hardness of 10 GPa or more is formed on a surface thereof.

### Background Art

Non-Patent Document 1 and Patent Document 1 relate to the formation of a diamond-like carbon (DLC) film by the plasma chemical vapor deposition (CVD) method under a pressure around atmospheric pressure. Non-Patent Document 1 and Patent Document 1 describe that a helium (He) gas is used as a carrier gas.

Non-Patent Document 1 mentions that a discharge plasma is generated in a gas mixture containing a helium gas and a methane (CH₄) gas, to thereby form a DLC film having a film hardness of 20.8 GPa on the surface of the substrate made of silicon (Si).

Patent Document 1 mentions that a discharge plasma is generated in a gas mixture containing a helium gas and a methane gas, to thereby form a DLC film having a film hardness of 20.9 GPa on the surface of the substrate made of iron (Fe) or the like.

### Prior Art Documents

### Patent Document

Patent Document 1: Japanese Patent Application Laid-Open No. 2009-84591 Non-Patent Document

Non-Patent Document 1: Naoto Ohtake and five others, "Synthesis of Diamond-like Carbon Films by Nanopulse Plasma Chemical Vapor Deposition at Subatmospheric Pressure", Japanese Journal of Applied Physics, Japan Society of Applied Physics, 2004, Vol. 43, No. 11A, pp. L1406 to L1408

### Summary of Invention

### Problem to be Solved by the Invention

When a DLC film is formed by the method described in Non-Patent Document 1 or Patent Document 1, the DLC film may peel off the surface of the substrate in some cases.

The present invention has been made to solve this problem, and an object thereof is to provide a method of manufacturing a DLC film formed body in which peeling-off of the DLC film is suppressed.

### Means to Solve the Problem

In order to solve the above-mentioned problem, the following means are employed.

A first invention relates to a method of manufacturing a diamond-like carbon film formed body in which a diamond-like carbon film having a film hardness of 10 GPa or more is formed on a surface thereof, the method including the steps of: (a) housing a conductive base inside a chamber; (b) supplying a first gas mixture containing 100 parts by volume of helium gas and 1 part by volume or more and 10 parts by volume or less of argon gas to the inside of the chamber in which the base is housed while adjusting a pressure inside of the chamber in which the base is housed to 20 hPa or higher and an atmospheric pressure or lower; (c) generating a discharge plasma in the first gas mixture inside of the chamber in a state in which the pressure inside of the chamber is adjusted to 20 hPa or higher and an atmospheric pressure or lower, and pretreating a surface of the base with the discharge plasma; (d) forming a silicon carbide film on the surface of the base pretreated with the discharge plasma; and (e) forming a diamond-like carbon film so as to overlie the silicon carbide film formed on the surface of the base.

According to a second invention, in the method of manufacturing a diamond-like carbon film formed body according to the first invention, the first gas mixture further contains 1 part by volume or more and 10 parts by volume or less of hydrogen gas.

According to a third invention, in the method of manufacturing a diamond-like carbon film formed body according to the first or second, in the step (c), a DC pulse is repeatedly applied to an electrode pair opposed to each other with the base being sandwiched therebetween to generate a glow plasma discharge in the first gas mixture.

According to a fourth invention, in the method of manufacturing a diamond-like carbon film formed body according to the third invention, introduced energy by a DC pulse is 1 mJ or more and 10 mJ or less per pulse.

According to a fifth invention, in the method of manufacturing a diamond-like carbon film formed body according to the third invention, introduced power per unit area obtained by dividing introduced power by a DC pulse by an opposing area of the electrode pair is 50 W/cm² or more.

According to a sixth invention, the method of manufacturing a diamond-like carbon film formed body according to any of the first to fifth inventions further includes the step of (f) adjusting a temperature of the base to 150°C or higher and 300°C or lower before the surface of the base is pretreated with a discharge plasma.

According to a seventh invention, in the method of manufacturing a diamond-like carbon film formed body according to any of the first to sixth inventions, the step (d) includes the steps of: (d-1) supplying a second gas mixture containing 100 parts by volume of helium gas and 0.1 parts by volume or more and 5 parts by volume or less of tetramethylsilane gas to the inside of the chamber in which the base is housed while adjusting the pressure inside of the chamber in which the base is housed to 20 hPa or higher and an atmospheric pressure or lower; and (d-2) generating a discharge plasma in the second gas mixture inside of the chamber in a state in which the pressure inside of the chamber is adjusted to 20 hPa or higher and an atmospheric pressure or lower.

### Effects of the Invention

According to the present invention, the surface of the base is washed sufficiently before the formation of the DLC film, which suppresses peeling-off of the DLC film.

### Brief Description of Drawings

FIG. 1 is a cross-sectional view of a plasma treatment apparatus.
FIG. 2 is a perspective view of an injector electrode.
FIG. 3 is a vertical cross-sectional view of the injector electrode.
FIG. 4 is a figure showing a waveform of a DC pulse voltage.
FIG. 5 is a circuit diagram of an IES power supply.
FIG. 6 is a flowchart showing a procedure of manufacturing a DLC film formed body.
FIG. 7 is a cross-sectional view of the DLC film formed body.

### Embodiment for Carrying Out the Invention

These and other objects, features, aspects and advantages of the present invention will become more apparent from the following detailed description of the present invention when taken in conjunction with the accompanying drawings.

### <1.Outline>

The present embodiment relates to manufacturing of a DLC film formed body in which a DLC film is formed on a surface thereof. The DLC film is also referred to as a "diamond-like carbon film", "hard carbon film", "amorphous carbon film", "i-carbon film" or the like. In manufacturing of a DLC film formed body, prior to the formation of a DLC film, the surface of the base is pre-treated with a discharge plasma and a silicon carbide (SiC) film being an interlayer on the surface of the base is formed. The base is pre-treated, in a state where a gas mixture obtained by mixing a small amount of argon (Ar) gas into a helium (He) gas is in contact with the surface of the base, by generating a discharge plasma in the gas mixture. It is also desired to mix a small amount of hydrogen (H₂) gas into to a helium gas in addition to the argon gas. Accordingly, the surface of the base is washed sufficiently prior to the formation of the DLC film, which suppresses peeling-off of the DLC film.

This method of manufacturing a DLC film formed body is particularly suitable for manufacturing of a DLC film formed body in which a hard DLC film having a film hardness of 10 GPa or more is formed on the surface thereof. This is because a harder DLC film has a larger residual stress and is more prone to peel off, and accordingly effects obtained by washing the surface of the base are more likely to appear.

### <2. Plasma treatment apparatus 1002>

### (Overall structure)

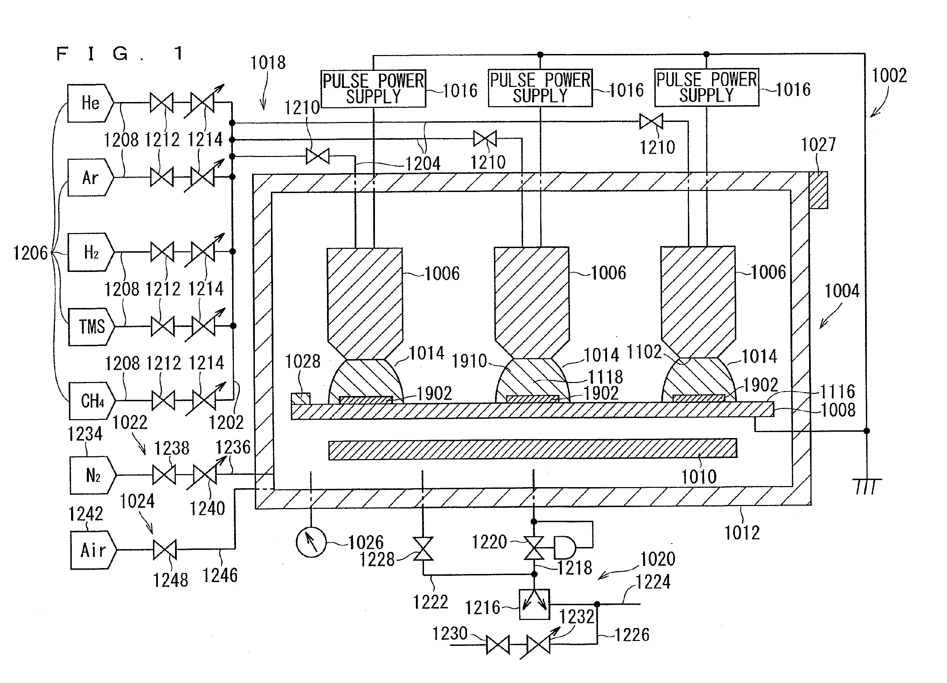

FIG. 1 is a schematic view of a plasma treatment apparatus (plasma CVD apparatus) 1002 used for manufacturing a DLC film formed body. FIG. 1 shows a cross-section of a reactor 1004 of the plasma treatment apparatus 1002 as well as shows an electric circuit and a gas circuit associated with the reactor 1004.

As shown in FIG. 1, the reactor 1004 of the plasma treatment apparatus 1002 has a structure in which injector electrodes (nozzle electrodes) 1006 also serving as injectors (nozzles) that inject a process gas, a support electrode 1008 also serving as a support that supports substrates 1902, and a heater 1010 that heats the substrates 1902 are housed in a chamber 1012.

Arranged in the chamber 1012 are a plurality of treatment parts 1014 that treat the substrates 1902. One injector electrode 1006 is provided for each of the plurality of treatment parts 1014. The support electrode 1008 is shared by the plurality of treatment parts 1014.

Connected to the reactor 1004 are pulse power supplies 1016 each of which applies a DC pulse voltage between the injector electrode 1006 and the support electrode 1008, a process gas supply circuit 1018 that supplies a process gas to the injector electrodes 1006, an exhaust gas discharge circuit 1020 that discharges an exhaust gas from the inside of the chamber 1012, a nitrogen gas supply circuit 1022 that supplies a nitrogen gas (N₂) to the inside of the chamber 1012, and an air supply circuit 1024 that supplies air to the inside of the chamber 1012. Further, the reactor 1004 is provided with a pressure sensor 1026 that measures a pressure inside of the chamber 1012, a temperature sensor 1028 that measures a temperature of the substrate 1902, and a cooling mechanism 1027 that cools the chamber 1012.

Desirably, one pulse power supply 1016 is provided correspondingly to each of the treatment parts 1014. Each of the plurality of pulse power supplies 1016 applies a DC pulse voltage between the injector electrode 1006 of the corresponding treatment part 1014 and the support electrode 1008. Accordingly, a DC pulse voltage is independently applied to each of the plurality of treatment parts 1014, and application of a DC pulse voltage between another injector electrode 1006 and the support electrode 1008 is not affected even when an arc discharge occurs in a gap 1118 between one injector electrode 1006 and the support electrode 1008, which suppresses a reduction in productivity due to an arc discharge.

In each of the plurality of treatment parts 1014, the plasma treatment apparatus 1002 treats the surface of the substrate 1902 supported by a support surface 1116 of the support electrode 1008 with a discharge plasma, by applying a DC pulse voltage between the injector electrode 1006 and the support electrode 1008 while injecting a process gas from the injector electrode 1006 to generate a discharge plasma in the process gas contained in the gap 1118 between the injector electrode 1006 and the support electrode 1008. One, or two or more of the substrates 1902 may be treated in each of the plurality of treatment parts 1014.

### (Injector electrode 1006)

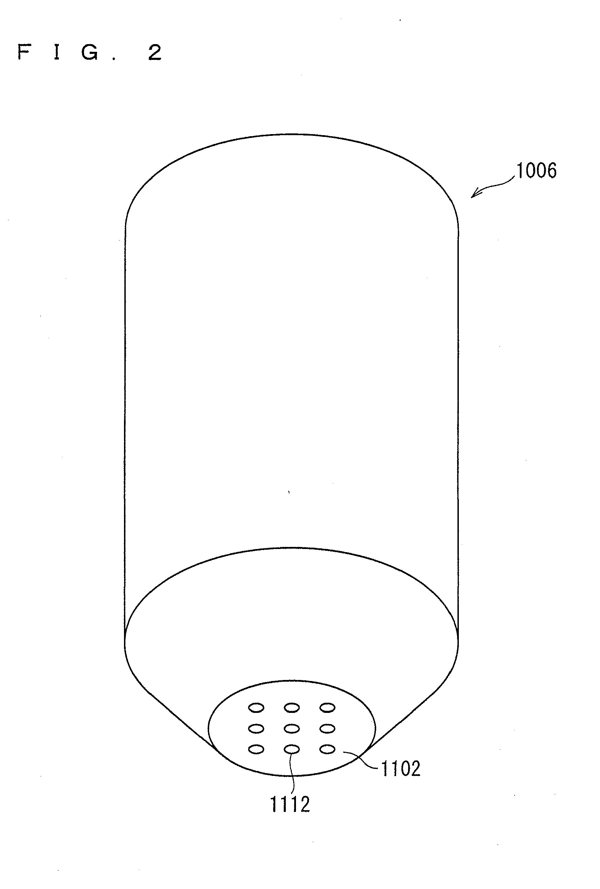

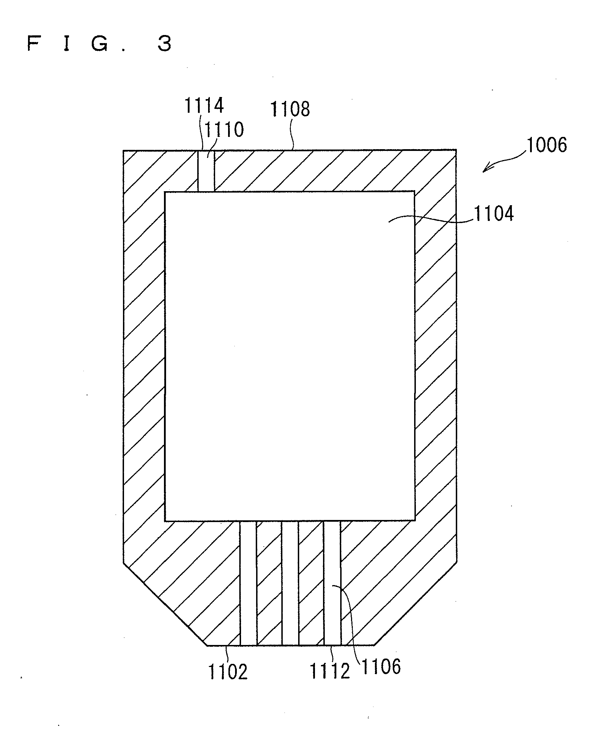

FIG. 2 and FIG. 3 are schematic views of the injector electrode 1006. FIG. 2 is a perspective view that is viewed from obliquely downward, and FIG. 3 is a vertical cross-sectional view showing the cross section perpendicular to an opposing surface 1102.

As shown in FIG. 2 and FIG. 3, the injector electrode 1006 has a three-dimensional shape in which a diameter in the vicinity of a bottom surface of a cylinder becomes smaller toward the bottom surface in a continuous manner, and a tip in a tapered portion serves as the opposing surface 1102. Needles to say, not only the vicinity of the bottom surface but also the entirety thereof may have a tapered structure.

The injector electrode 1006 is desirably made of, for example, iron, aluminum, alloys mainly containing iron (such as stainless steel, die steel and high-speed steel) or an alloy mainly containing aluminum. Note that the material of the injector electrode 1006 may be changed, or the surface of the injector electrode 1006 may be coated with tungsten, chrome, nickel or the like.

As shown in FIG. 3, formed inside of the injector electrode 1006 are a gas reservoir 1104 for a process gas, a flow path 1106 for the process gas flowing from the gas reservoir 1104 to the opposing surface 1102, and a flow path 1110 for the process gas flowing from a non-opposing surface 1108 to the gas reservoir 1104. As a result, injection holes 1112 for the process gas are formed in the opposing surface 1102, and a supply hole 1114 for the process gas is formed in the non-opposing surface 1108. The "opposing surface" is the surface of the injector electrode 1006 that falls within the range in which it is opposed to the support surface 1116 of the support electrode 1008 in a parallel manner, while the "non-opposing surface" is the remaining surface of the injector electrode 1006 except for the "opposing surface". The injector electrode 1006 is placed such that the opposing surface 1102 is horizontal.

The injector electrode 1006 receives the process gas through the supply hole 1114, temporarily stores the process gas in the gas reservoir 1104 and injects the process gas from the injection holes 1112 downwardly. As a result, the process gas is sprayed vertically onto the surface of the substrate 1902 supported by the support electrode 1008.

The injection hole 1112 desirably has a diameter of 1 to 4 mm. This is because the process gas tends to flow poorly if the diameter of the injection hole 1112 is smaller than this range, whereas the treatment is performed unevenly if the diameter of the injection hole 1112 is larger than this range.

### (Support electrode 1008)

The support electrode 1008 has an outer shape in which a plurality of holes are formed in a plate. The holes formed in the support electrode 1008 suppress a flow of gas from up to down from being hindered by the support electrode 1008. However, at times, the support electrode 1008 is not required in a case where a substrate has a cylindrical shape and the plasma treatment apparatus 1002 forms a film on the surface of the substrate while rotating the substrate.

The support electrode 1008 is desirably made of, for example, iron, aluminum, alloys mainly containing iron (such as stainless steel, die steel and high-speed steel) or an alloy mainly containing aluminum. Note that the material of the support electrode 1008 may be changed, or the surface of the support electrode 1008 may be coated with tungsten, chrome, nickel or the like.

The support electrode 1008 is a member referred to as "perforated metal".

The support electrode 1008 is placed horizontally and supports the substrates 1902 placed on the support surface (upper surface) 1116 from below.

### (Arrangement of injector electrode 1006 and support electrode 1008)

The injector electrode 1006 and the support electrode 1008 are arranged so as to be vertically apart from each other, and the opposing surface 1102 of the injector electrode 1006 and the support surface 1116 of the support electrode 1008 are opposed to each other with the gap 1118 being sandwiched therebetween. The gap 1118 desirably has a width of 1 to 20 mm. This is because an arc discharge is more prone to occur if the width of the gap 1118 becomes smaller than this range, whereas a glow plasma discharge is less prone to occur if the width of the gap 1118 is larger than this range.

### (Coating of injector electrode 1006 and support electrode 1008)

It is desirable that the opposing surface 1102 of the injector electrode 1006 and the support surface 1116 of the support electrode 1008 be not coated with a dielectric barrier but conductors thereof be exposed. This is because ions are prevented from moving in a discharge plasma as a result of the opposing surface 1102 and the support surface 1116 being coated with a dielectric barrier, which inhibits the formation of a film on the surface of the substrate 1902. Although an arc discharge is prone to occur if the opposing surface 1102 and the support surface 1116 are not covered with a dielectric barrier, a reduction in productivity due to an arc discharge is suppressed in the plasma treatment apparatus 1002 by providing one pulse power supply 1016 correspondingly to each of the plurality of treatment parts 1014, which does not lead to a serious problem. Further, in the case where the opposing surface 1102 and the support surface 1116 are not coated with a dielectric barrier, a discharge is less prone to occur upon application of an AC pulse between the injector electrode 1006 and the support electrode 1008. When a discharge occurs, unfortunately, an arc occurs in many cases.

### (Process gas supply circuit 1018)

As shown in FIG. 1, the process gas supply circuit 1018 is connected to the supply holes 1114 of the injection electrodes 1006. The process gas supplied by the process gas supply circuit 1018 varies depending on the treatment performed by the plasma treatment apparatus 1002.

The process gas supply circuit 1018 includes a component gas joining pipe 1202 in which the component gases contained in the process gas join, process gas flowing pipes 1204 serving as flowing paths for the process gas from the component gas joining pipe 1202 to the injector electrodes 1006, component gas flowing pipes 1208 serving as flowing paths for the component gases from sources 1206 of the component gases to the component gas joining pipe 1202, valves 1210 that allow or block the flow of the process gas through the process gas flowing pipes 1204, valves 1212 that allow or block the flow of component gases through the component gas joining pipe 1202, and flow amount control valves 1214 that control a flow amount of the component gases flowing through the component gas joining pipe 1202.

One end of each of a plurality of process gas flowing pipes 1204 is connected to the supply hole 1114 of one injector electrode 1006. The other end of each of the plurality of process gas flowing pipes 1204 is connected to the component gas joining pipe 1202. One valve 1210 is interposed in each of the plurality of process gas flowing pipes 1204.

One end of each of a plurality of component gas flowing pipes 1208 is connected to one source 1206. The other end of each of the plurality of component gas flowing pipes 1208 is connected to the component gas joining pipe 1202. One valve 1212 and one flow amount control valve 1214 are interposed in each of the plurality of component gas flowing pipes 1208.

In FIG. 1, sources of helium gas (He), argon gas (He), hydrogen gas (H₂), tetramethylsilane gas (Si(CH₃)₄) and methane gas (CH₄) are prepared as the sources 1206 of the component gases. Needless to say, the component gas serving as a material of silicon (Si) may be changed to a gas of silicide other than a tetramethylsilane gas, or the component gas serving as a material of carbon (C) may be changed to a gas of organic compound other than a methane gas.

In a case where the process gas supply circuit 1018 supplies the process gas, the valves 1212, which are interposed in the component gas flowing pipes 1208 through which the component gases contained in the process gas flow, are opened, and the openings of the flow amount control valves 1214 interposed in the component gas flowing pipes 1208 through which the component gases contained in the process gas flow are adjusted such that a content ratio of component gases is equal to an expected content ratio, whereby the valves 1210 are opened. This allows the process gas containing component gases at the expected content ratio is ejected from the injection holes 1112 of the injector electrodes 1006 toward the surfaces of the substrates 1902.

### (Exhaust gas discharge circuit 1020)

The exhaust gas discharge circuit 1020 includes an exhaust gas flowing pipe 1218 serving as a flowing path for an exhaust gas from a discharge port provided on a lower surface of the chamber 1012 to an inlet port of a dry pump 1216, an exhaust gas flowing pipe 1222 serving as a flowing path for the exhaust gas from a discharge port provided on the lower surface of the chamber 1012 to the exhaust gas flowing pipe 1218 without involving a pressure control valve 1220, the dry pump 1216 that sucks and discharges an exhaust gas, an exhaust gas flowing pipe 1224 serving as a flowing path for the exhaust gas from a discharge port of the dry pump 1216 to the outside, a diluent gas flowing pipe 1226 that introduces a diluent gas for diluting the exhaust gas into the exhaust gas flowing pipe 1224, the pressure control valve 1220 that controls a primary pressure, a valve 1228 that allows or blocks the flow of the exhaust gas through the exhaust gas flowing pipe 1222, a valve 1230 that allows or blocks the flow of the diluent gas through the diluent gas flowing pipe 1226, and a flow amount control valve 1232 that controls a flow amount of the diluent gas flowing through the diluent gas flowing pipe 1226.

The pressure control valve 1220 is interposed in the exhaust gas flowing pipe 1218, and the valve 1228 is interposed in the exhaust gas flowing pipe 1222. The valve 1230 and the flow amount control valve 1232 are interposed in the diluent gas flowing pipe 1226.

In a case where the exhaust gas discharge circuit 1020 discharges an exhaust gas rapidly, the valve 1228 is opened and the dry pump 1216 is operated.

In a case where the exhaust gas discharge circuit 1020 discharges an exhaust gas while keeping the pressure inside of the chamber 1012, the valve 1228 is closed, and the pressure control valve 1220 is adjusted such that the pressure inside of the chamber 1012 becomes equal to an expected pressure, whereby the dry pump 1216 is operated.

### (Nitrogen gas supply circuit 1022)

The nitrogen gas supply circuit 1022 includes a nitrogen gas flowing pipe 1236 serving as a flowing path for a nitrogen gas (N₂) from the source 1234 of a nitrogen gas to a supply port provided on a side surface of the chamber 1012, a valve 1238 that allows or blocks the flow of the nitrogen gas through the nitrogen gas flowing pipe 1236, and a flow amount control valve 1240 that adjusts a flow amount of the nitrogen gas flowing through the nitrogen gas flowing pipe.

### (Air supply circuit 1024)

The air supply circuit 1024 includes an air flowing pipe 1246 serving as a flowing path for air from the source 1242 of air to a supply port provided on the side surface of the chamber 1012, and a valve 1248 that allows or blocks the flow of air through the air flowing pipe 1246.

### (DC pulse voltage)

The DC pulse voltage repeatedly applied between the injector electrode 1006 and the support electrode 1008 from the pulse power supply 1016 is desirably a DC pulse voltage that generates a glow plasma discharge in the gap 1118 and rises quickly. A streamer discharge that does not shift to an arc discharge may occur in part of the gap 1118.

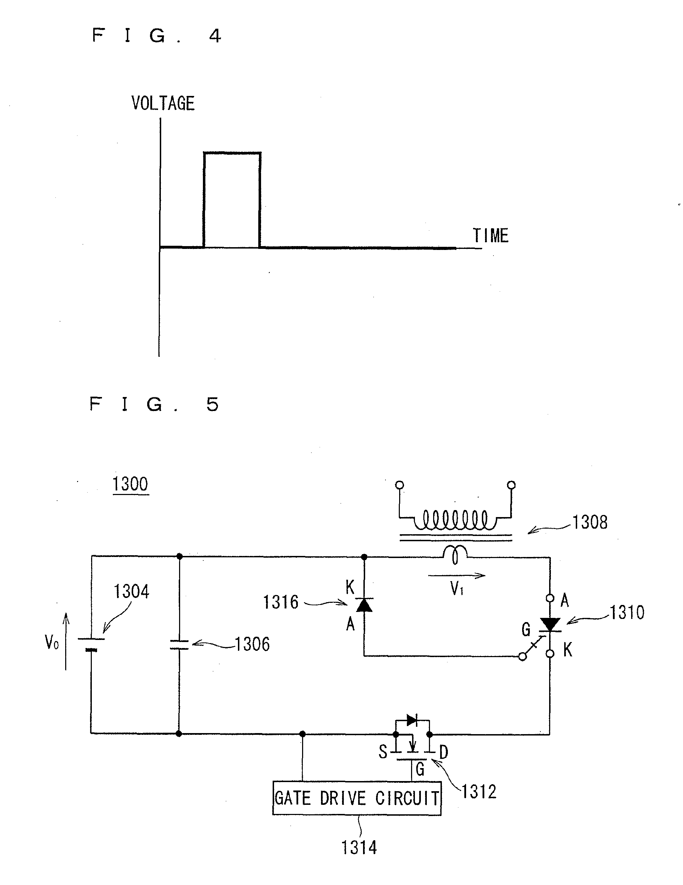

A DC pulse voltage for generating a glow plasma discharge is a DC pulse voltage whose peak voltage is approximately 0.1 to 20 kV, full width at half maximum (FWHM) is approximately 100 to 5,000 ns, rate of voltage rise with respect to time dV/dt when rising is approximately 0.1 to 100 kV/µs, and frequency is approximately 1 to 200 kHz. As shown in FIG. 4, the DC pulse voltage is a monopolar DC pulse voltage whose polarity does not change.

While a glow plasma discharge is occurring in the gap 1118, as shown in FIG. 1, a light-emitting plasma 1910 is observed in the gap 1118.

The reason why the ranges of FWHM and the like are described above using "approximately" is that in some cases, the ranges of FWHM and the like when a glow plasma discharge occurs become wider than the above-mentioned ranges depending on the structure and treatment conditions of the plasma treatment apparatus 1002 such as the structures and materials of the injector electrode 1006 and the support electrode 1008, the interval of the gap 1118 and a pressure of a process gas. Therefore, it is desirable to judge whether or not a discharge is a glow plasma discharge through observation of an actual discharge.

### (Type of pulse power supply 1016)

It suffices that the pulse power supply 1016 outputs a DC pulse voltage for generating a glow plasma discharge without generating an arc discharge, which is desirably an inductive energy storage (IES) power supply (hereinafter, referred to as "IES power supply") that releases, in a short period of time, the energy stored in an inductive element in the form of a magnetic field. This is because the IES power supply is capable of introducing much larger energy with high repetition frequency compared with a capacitive energy storage (CES) power supply (hereinafter, referred to as "CES power supply") that releases, in a short period of time, the energy stored in a capacitive element in the form of a electric field. Typically, with the same electrode structure, when the IES power supply is employed, the introduced energy per pulse (hereinafter, referred to as "one-pulse energy") used in the reaction for generating a discharge plasma becomes larger by approximately one digit compared with a case where a CES power supply is employed. This difference between the IES power supply and the CES power supply results from the fact that the DC pulse voltage generated by the CES power supply rises slowly, whereas the DC pulse voltage generated by the IES power supply rises abruptly. That is, in the case of employing the IES power supply, a discharge is started after a voltage rises sufficiently, which results in that one-pulse energy becomes sufficiently large and in-plane discharge uniformity is high. Meanwhile, in the case of employing the CES power supply, a discharge is started before a voltage rises sufficiently, which results in that one-pulse energy does not become sufficiently large and in-plane discharge uniformity is poor.

### (Switching element)

It is desirable to employ, as the IES power supply, a power supply in which a static induction thyristor (hereinafter, referred to as "SI thyristor") is used as a switching element that controls current supply to an inductive element. This is because a DC pulse voltage that rises rapidly is generated in the case of using an SI thyristor as a switching element. The reason why a DC pulse voltage that rises rapidly is generated in the case of using an SI thyristor as a switching element is that a gate is not insulated and a carriers are released from the gate at high speed, and accordingly the SI thyristor turns off at high speed. The details of operating principle or the like of an IES power supply are described in, for example, Katsuji Iida and Takeshi Sakuma, "Extremely Short Pulse Generation Circuit (IES circuit) by SI Thyristor", Symposium of Static Induction Devices, proceedings, Vol. 15, pp. 40 to 45 (published on June 14th, 2002).

### (IES power supply 1300)

FIG. 5 is a circuit diagram of an IES power supply 1300 preferably used for the pulse power supply 1016 in which an SI thyristor 1310 is used as a switching element. Needless to say, the circuit diagram shown in FIG. 5 is merely an example, and various modifications can be made.

As shown in FIG. 5, the IES power supply 1300 includes a DC power supply 1304 that supplies electric energy and a capacitor 1306 that enhances the dischargeability of the DC power supply 1304.

The voltage of the DC power supply 1304 is allowed to be considerably lower than the peak voltage of the DC pulse voltage generated by the IES power supply 1300. For example, it suffices that the voltage of the DC power supply 1304 is several ten volts to several hundred volts even when a peak voltage of a primary voltage V 1 generated on a primary side of a stepup transformer 1308 described below reaches 4 kV. A lower limit of this voltage is determined by a latching voltage of the SI thyristor 1310 described below.

The capacitor 1306 is connected in parallel with the DC power supply 1304. The capacitor 1306 apparently reduces an impedance of the DC power supply 1304 and enhances the dischargeability of the DC power supply 1304.

The IES power supply 1300 further includes the stepup transformer 1308, the SI thyristor 1310, a metal oxide semiconductor field effect transistor (MOSFET) 1312, a gate drive circuit 1314 and a diode 1316.

In the IES power supply 1300, the DC power supply 1304, the primary side of the stepup transformer 1308, a portion between an anode (A) and a cathode (K) of the SI thyristor 1310, and a portion between a drain (D) and a source (S) of the MOSFET 1312 are connected in series. That is, one end on the primary side of the stepup transformer 1308 is connected to a positive electrode of the DC power supply 1304, the other end on the primary side of the stepup transformer 1308 is connected to the anode of the SI thyristor 1310, the cathode (K) of the SI thyristor 1310 is connected to the drain (D) of the MOSFET 1312, and the source (S) of the MOSFET 1312 is connected to a negative electrode of the DC power supply 1304. As a result, a closed circuit that supplies a current from the DC power supply 1304 to those circuit elements is formed. Further, in the IES power supply 1300, a gate (G) of the SI thyristor 1310 is connected to the one end on the primary source of the stepup transformer 1308 via the diode 1316. That is, the gate (G) of the SI thyristor 1310 is connected to an anode (A) of the diode 1316, a cathode (K) of the diode 1316 is connected to the one end (positive electrode of the DC power supply 1304) on the primary side of the stepup transformer 1308. The gate drive circuit 1314 is connected between a gate (G) and the source (S) of the MOSFET.

The stepup transformer 1308 further boosts the DC pulse voltage provided to the primary side and then outputs it to a secondary side. One end on the secondary side of the stepup transformer 1308 is connected to the support electrode 1008 and is also connected to ground, and the other end thereof is connected to the injector electrode 1006.

The SI thyristor 1310 turns on and turns off by a signal supplied to the gate (G).

The MOSFET 1312 is a switching element in which a conduction state between the drain (D) and the source (S) changes in response to the signal supplied from the gate drive circuit 1314. It is desired that an on-voltage or on-resistance of the MOSFET 1312 be low. In addition, a breakdown voltage of the MOSFET 1312 is required to be higher than the voltage of the DC power supply 1304.

The diode 1316 is provided for releasing the carriers stored in the SI thyristor 1310 at high speed immediately after the MOSFET 1312 turns off and causing the SI thyristor 1310 to turn off at high speed.

### (Action of IES power supply 1300)

In a case where a DC pulse voltage is generated in the IES power supply 1300, first, an on-signal is supplied from the gate drive circuit 1314 to the gate of the MOSFET 1312, to thereby provide a conduction state between the drain (D) and the source (S) of the MOSFET 1312. Then, a current flows through the primary side of the stepup transformer 1308 because the SI thyristor 1310 is a normally-on switching element and a conduction state is provided between the anode (A) and the cathode (K) of the SI thyristor 1310. In this state, a positive bias is applied to the gate (G) of the SI thyristor 1310, and thus the conduction state between the anode (A) and the cathode (K) of the SI thyristor 1310 is maintained.

Then, the supply of the on-signal from the gate drive circuit 1314 to the MOSFET 1312 is stopped, to thereby provide a non-conduction state between the drain (D) and the source (S) of the MOSFET 1312. As a result, carriers are discharged from the gate (G) of the SI thyristor 1310 by current driving at high speed, and the non-conduction state is provided between the anode (A) and the cathode (K) of the SI thyristor 1310, whereby a current inflow toward the primary side of the stepup transformer 1308 is stopped at high speed. This causes an induced electromotive force on the primary side of the stepup transformer 1308 and also causes a high voltage on the secondary side of the stepup transformer 1308.

### (Heater 1010)

The heater 1010 is provided below the support electrode 1008. The heater 1010 is, for example, a ceramic heater that irradiates far infrared rays. A stage heater , a sheathed heater or the like that is in contact with the substrate 1902 to directly heat the substrates 1902 may be used in place of the ceramic heater that heats the substrates 1902 apart from the substrates 1902.

### (Chamber 1012)

The chamber 1012 is a stainless container. The inside of the chamber 1012 is a closed space.

### (Object to be treated)

A shape of an object to be treated by the plasma treatment apparatus 1002 is not particularly limited. Accordingly, a DLC film is formed by the plasma treatment apparatus 1002 also on the surface of a base other than a plate-like base such as the substrate 1902, for example, a mold for ceramic molding, a tool for cutting or car parts. A DLC film is formed on a base having a cylindrical shape by forming a film on the surface of the base while rotating the base.

A material of the substrate 1902 is not particularly limited as well. Note that the plasma treatment apparatus 1002 is preferably used in a case where a DLC film is formed on the surface of the conductive substrate 1902 made of a material having a small volume resistivity, for example, a metal or alloy having a much smaller volume resistivity than silicon having high purity and small volume resistivity used for semiconductors. This is because in a case where a DLC film is formed on the surface of the conductive substrate 1902, an arc discharge is likely to occur, but in the plasma treatment apparatus 1002, a reduction in productivity due to an arc discharge is suppressed by providing one pulse power supply 1016 correspondingly to each of the plurality of treatment parts 1014.

Examples of the metal or alloy having a much smaller volume resistivity than silicon having high purity and small volume resistivity used for semiconductors include iron and alloys mainly containing iron, for example, stainless steel, die steel and high-speed steel. Examples of the stainless steel include SUS304, SUS420, SUS430 and SUS440, examples of the die steel include SKD11 and SKD61, and examples of the high-speed steel include SKH51 and SKH55.

Additionally, other examples of the material of an object to be treated include alloys mainly containing aluminum or copper.

### <3. Manufacturing of DLC film formed body>

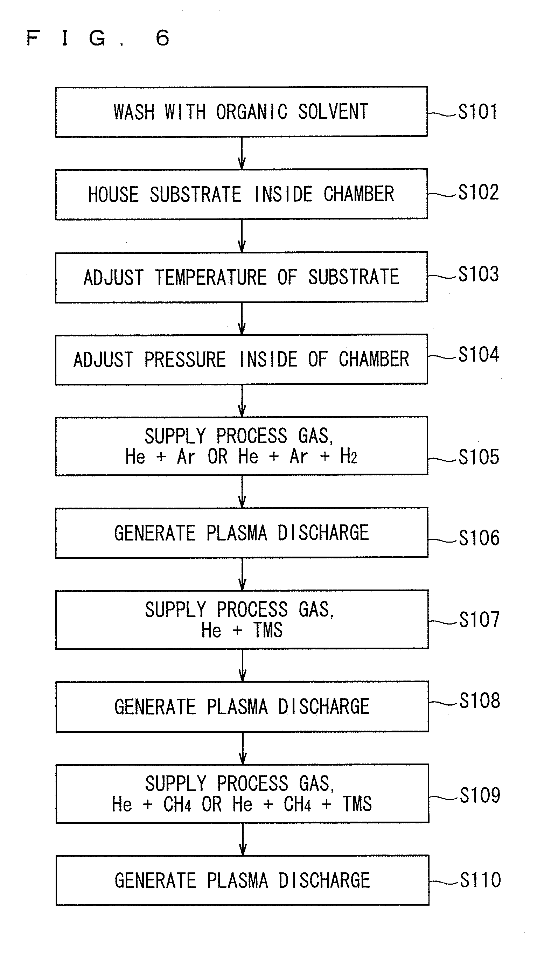

FIG. 6 is a flowchart showing an example of the manufacturing procedure in a case where a DLC film formed body in which a DLC film is formed on the surface thereof is manufactured by the plasma treatment apparatus 1002 using the substrate 1902 made of an alloy mainly containing iron. The plasma treatment apparatus 1002 may be manually operated, automatically operated by a controller, or manually operated as well as automatically operated by a controller.

### (Washing with organic solvent)

In manufacturing of a DLC film formed body, first, the substrate 1902 is washed with an organic solvent such as acetone (Step S101). In place of washing with an organic solvent or in addition to washing with an organic solvent, the substrate 1902 may be washed with an acid or alkaline solvent. Ultrasonic waves may be irradiated during washing.

### (Housing inside chamber)

After being washed with an organic solvent, the substrate 1902 is housed inside the chamber 1012 (Step S102). The substrate 1902 housed inside the chamber 1012 is placed on the support surface 1116 of the support electrode 1008 below the injector electrode 1006.

### (Pretreatment with discharge plasma)

After being housed inside the chamber, the surface of the substrate 1902 is pretreated with a discharge plasma, to thereby remove an organic material, oxide film and the like that adhered to the surface of the substrate 1902 (Steps S103 to S106).

In the pretreatment with a discharge plasma, first, the substrate 1902 placed on the support surface 1116 of the support electrode 1008 is heated by the heater 1010 while monitoring the temperature of the substrate 1902 by the temperature sensor 1028, to thereby adjust the temperature of the substrate 1902 placed on the support surface 1116 of the support electrode 1008 (Step S103). The adjustment of the temperature of the substrate 1902 may be completed before the surface of the substrate 1902 is treated with a discharge plasma in Step S105.

Then, the pressure inside of the chamber 1012 in which the substrate 1902 is housed is adjusted by the exhaust gas discharge circuit 1020 while keeping the state in which the temperature of the substrate 1902 is adjusted (Step S104), and the process gas is supplied inside the chamber 1012 in which the substrate 1902 is housed by the process gas supply circuit 1018 (Step S105).

The process gas used for pretreatment with a discharge plasma is desirably a gas mixture obtained by mixing 1 part by volume or more and 10 parts by volume or less of argon gas into 100 parts by volume of helium gas, and more desirably, a gas mixture obtained by mixing 1 part by volume or more and 10 parts by volume or less of argon gas and 1 part by volume or more and 10 parts by volume or less of hydrogen gas into 100 parts by volume of helium gas. This is because, if the mixing ratio of the component gases falls within this range, a glow plasma discharge is maintained without reaching an arc discharge, and also the surface of the substrate 1902 is washed sufficiently, which suppresses peeling-off of a DLC film. It is considered that an argon gas mainly contributes to washing of the surface owing to the ion bombardment effect and that a hydrogen gas mainly contributes to washing of the surface owing to the chemical etching effect.

Then, while keeping the state in which the temperature of the substrate 1902 is adjusted, the state in which the pressure inside of the chamber is adjusted, and the mixing ratio of the component gases of the process gas, a DC pulse is repeatedly applied between the injector electrode 1006 and the support electrode 1008 opposed to each other with the substrate 1902 being sandwiched therebetween while continuing supply of the process gas, to thereby generate a glow plasma discharge in the process gas inside of the chamber 1012 (Step S106). As a result, a discharge plasma is generated in the process gas, and the discharge plasma acts on the surface of the substrate 1902, whereby the surface of the substrate 1902 is treated with the discharge plasma.

### (Formation of silicon carbide film)

After the pretreatment with a discharge plasma, an amorphous silicon carbide film is formed on the surface of the substrate 1902 treated with a discharge plasma (Steps S107 and S108). This amorphous silicon carbide film is a film having a composition in which hydrogen is further contained in the composition composed of silicon and carbon.

In the formation of a silicon carbide film, first, while keeping the state in which the temperature of the substrate 1902 is adjusted and the state in which the pressure inside of the chamber 1012 is adjusted, the process gas is supplied inside the chamber 1012 in which the substrate 1902 is housed by the process gas supply circuit 1018 (Step S107).

The process gas used for the formation of a silicon carbide film is desirably a gas mixture obtained by mixing 0.1 parts by volume or more and 5 parts by volume or less of tetramethylsilane gas into 100 parts by volume of helium gas. This is because, if the mixing ratio of the component gases falls within this range, a glow plasma discharge is maintained without reaching an arc discharge, and also the silicon carbide film being an interlayer is appropriately formed on the surface of the substrate 1902, which suppresses peeling-off of a DLC film.

Then, while keeping the state in which the temperature of the substrate 1902 is adjusted, the state in which the pressure inside of the chamber 1012 is adjusted, and the mixing ratio of the component gases of the process gas, a DC pulse is repeatedly applied between the injector electrode 1006 and the support electrode 1008 opposed to each other with the substrate 1902 being sandwiched therebetween while continuing supply of the process gas, to thereby generate a glow plasma discharge in the process gas inside of the chamber 1012 (Step S108). As a result, a discharge plasma is generated in the process gas, whereby a silicon carbide film is formed on the surface of the substrate 1902.

### (Formation of DLC film)

After the formation of the silicon carbide film, a DLC film is formed so as to overlie the silicon carbide film (Steps S109 and S110).

In the formation of a DLC film, while keeping the state in which the temperature of the substrate 1902 is adjusted and the state in which the pressure inside of the chamber 1012 is adjusted, the process gas is supplied inside the chamber 1010 in which the substrate 1902 is housed by the process gas supply circuit 1018 (Step S109).

The process gas used for the formation of a DLC film is desirably a gas mixture obtained by mixing 0.1 parts by volume or more and 30.0 parts by volume or less of methane gas into 100 parts by volume of helium gas, and more desirably, a gas mixture obtained by mixing 0.1 parts by volume or more and 30.0 parts by volume or less of methane gas and 0.05 parts by volume or more and 2.0 parts by volume or less of tetramethylesilane gas into 100 parts by volume of helium gas. This is because, if the mixing ratio of the component gases falls within this range, a glow plasma discharge is maintained without reaching an arc discharge, and peeling-off of a DLC film is suppressed.

Then, while keeping the state in which the temperature of the substrate 1902 is adjusted, the state in which the pressure inside of the chamber 1012 is adjusted, and the mixing ratio of the component gases of the process gas, a DC pulse is repeatedly applied between the injector electrode 1006 and the support electrode 1008 opposed to each other with the substrate 1902 being sandwiched therebetween while continuing supply of the process gas, to thereby generate a glow plasma discharge in the treatment part 1014 (Step S110). As a result, a discharge plasma is generated in the process gas, whereby a DLC film is formed so as to overlie the silicon carbide film.

### (Manufacturing of DLC film formed body)

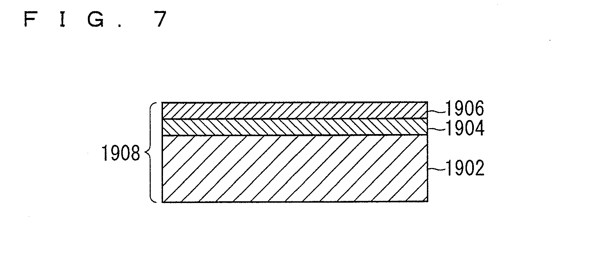

FIG. 7 is a schematic view of a DLC film formed body 1908 manufactured by the above-mentioned manufacturing procedure. FIG. 7 is a cross-sectional view of the DLC film formed body 1908.

As shown in FIG. 7, the DLC film formed body 1908 has a laminated structure in which a silicon carbide film 1904 is formed on the surface of the substrate 1902, and a DLC film 1906 is formed on the surface of the silicon carbide film 1904.

### (Temperature of substrate 1902)

It is desired that the temperature of the substrate 1902 in the pretreatment with a discharge plasma, the formation of a silicon carbide film and the formation of a DLC film be adjusted to 150°C or higher and 300°C or lower. This is because the treatment is performed sufficiently without damaging the base 1902 if the temperature of the substrate 1902 falls within this range.

The temperature of the substrate 1902 is not required to be kept uniform through the pretreatment with a discharge plasma, the formation of a silicon carbide film and the formation of a DLC film, and all or a part of the temperature of the substrate 1902 in the pretreatment with a discharge plasma, the temperature of the substrate 1902 in the formation of the silicon carbide film, and the temperature of the substrate 1902 in the formation of the DLC film may vary.

### (Pressure of process gas)

The pressure of the process gas in the pretreatment with a discharge plasma, the formation of a silicon carbide film and the formation of a DLC film is adjusted to 20 hPa or higher and atmospheric pressure or lower. This is because if the pressure of the process gas falls within this range, the treatment is accelerated, leading to enhancement of productivity. While an arc discharge is more likely to occur as the pressure inside of the chamber 1012 becomes higher, in the plasma treatment apparatus 1002, a reduction in productivity due to an arc discharge is suppressed by providing one pulse power supply 1016 correspondingly to each of the plurality of treatment parts 1014, which does not cause a serious problem.

The pressure of the process gas is not required to be maintained through the pretreatment with a discharge plasma, the formation of a silicon carbide film and the formation of a DLC film, and all or a part of the pressure of the process gas in the pretreatment with a discharge plasma, the pressure of the process gas in the formation of the silicon carbide film, and the pressure of the process gas in the formation of the DLC film may vary.

It is not necessarily required to perform the pretreatment with a discharge plasma, the formation of a silicon carbide film and the formation of a DLC film inside one chamber 1012, which may be performed inside different chambers 1012. In this case, the substrate 1902 is conveyed from one chamber 1202 to another chamber 1202 by a robot arm, a conveyer belt or the like.

### (Power to be introduced)

The introduced power per unit area obtained by dividing the introduced power with a DC pulse in the pretreatment with a discharge plasma, the formation of a silicon carbide film and the formation of a DLC film by an opposing area in which the opposing surface 1102 of the injector electrode 1006 is opposed to the support surface 1116 of the support electrode 1008 is desirably 50 W/cm² or more. This is because the treatment is accelerated and productivity is enhanced if the introduced power per unit area falls within this range.

The introduced energy with a DC pulse is desirably 1 mJ or more and 10 mJ or less per pulse.

### <4. Prototype of DLC film formed body>

Prototypes of DLC film formed bodies are built by variously changing a mixing ratio of component gases of a process gas in the pretreatment with a discharge plasma, the formation of a silicon carbide film and the formation of a DLC film, and an influence of the mixing ratio of component gases of the process gas on a discharge state and peeling-off load of a DLC film was observed. The material of the used substrate is SUS440C. Table 1 shows the treatment conditions for a prototype of a DLC film formed body.

**[Table 1]**

| | | |
|---|---|---|
| Pretreatment with discharge plasma | Pressure inside of chamber | 173.3 hPa |
| | Flow amount of helium gas | 1,400 sccm |
| | Temperature of substrate | 200°C |
| | Treatment time period | 1 minute |
| | Peak voltage of DC pulse | 2 kV |
| | FWHM of DC pulse | 2 µ seconds |
| Formation of SiC film | Pressure inside of chamber | 173.3 hPa |
| | Flow amount of helium gas | 1,400 sccm |
| | Temperature of substrate | 200°C |
| | Treatment time period | 30 seconds |
| | Peak voltage of DC pulse | 2 kV |
| | FWHM of DC pulse | 1.2 µ seconds |
| Formation of DLC film | Pressure inside of chamber | 173.3 hPa |
| | Flow amount of helium gas | 1,400 sccm |
| | Temperature of substrate | 200°C |
| | Treatment time period | 2 minutes |
| | Peak voltage of DC pulse | 2 kV |
| | FWHM of DC pulse | 1.2 µ seconds |

The peeling-off load of a DLC film was measured with HEIDON: TYPE-32 from Shinto Scientific Co., Ltd. (Chiyoda-ku, Tokyo). The peeling-off load of the DLC film was measured by a scratch test in which a DLC film is scratched with a diamond penetrator while increasing a pressing load, to thereby specify the load for causing peeling-off in a DLC film. The used diamond penetrator had a radius of 50 µm at its tip, and the length of a scratch in the DLC film was 5 mm. The scratch test is typically performed with a diamond penetrator having a radius of 200 µm at its tip, and thus the peeling-off load described below was converted into a value in a case where a diamond penetrator having a radius of 200 µm at its tip was used, that is, a value 16 times a measured value in a case where a diamond penetrator having a radius of 50 µm at its tip was used.

The film hardness of a DLC film was measured with Nano Indenter from MTS Systems Corporation.

### (Influence of mixing ratio in formation of silicon carbide film)

Table 2 shows the mixing ratio of component gases in the process gas, a discharge state in the formation of a silicon carbide film and a peeling-off load of a DLC film of prototype numbers 1A, 1B, 1C, 1D, 1E and 1F in which the mixing ratio of component gases was variously changed in forming a silicon carbide film.

**[Table 2]**

| Prototype No. | | 1A | 1B | 1C | 1D | 1E | 1F |
|---|---|---|---|---|---|---|---|
| Pretreatment with discharge plasma | He (parts by volume) | 100 | | | | | |
| | H₂ (parts by volume) | 1.8 | | | | | |
| | Ar (parts by volume) | 0 | | | | | |
| Formation of SiC film | He (parts by volume) | 100 | | | | | |
| | TMS (parts by volume) | 0 | 0.1 | 0.7 | 1.0 | 5.0 | 7.0 |
| Formation of DLC film | He (parts by volume) | 100 | | | | | |
| | TMS (parts by volume) | 0 | | | | | |
| | CH₄ (parts by volume) | 11.4 | | | | | |
| Discharge state | | Glow | Glow | Glow | Glow | Glow | Arc |
| Peeling-off load | | 16 N | 24 N | 24 N | 24 N | 24 N | ··· |

As shown in Table 2, when the mixing amount of a tetramethylsilane (TMS) gas to 100 parts by volume of helium gas in the process gas in the formation of a silicon carbide film was 0.1 parts by volume or more and 5.0 parts by volume or less, a glow plasma discharge was maintained and a peeling-off load was good. However, a mixing amount of tetramethylsilane gas falling below this range reduced a peeling-off load, and a mixing amount of tetramethylsilane gas exceeding this range generated an arc discharge.

The film hardness of the DLC film of each of the prototype numbers 1A, 1B, 1C, 1D and 1E was measured, which exceeded 10 GPa.

### (Influence of mixing ratio in pretreatment with discharge plasma: as to mixing amount of argon gas)

Table 3 shows the mixing ratio of component gases in the process gas, a discharge state in the pretreatment with a discharge plasma and a peeling-off load of a DLC film of prototype numbers 2A, 2B, 2C, 2D, 2E and 2F in which the mixing ratio of component gases was variously changed in the pretreatment with a discharge plasma.

**[Table 3]**

| Prototype No. | | 2A | 2B | 2C | 2D | 2E | 2F |
|---|---|---|---|---|---|---|---|
| Pretreatment with discharge plasma | He (parts by volume) | 100 | | | | | |
| | H₂ (parts by volume) | 1.8 | | | | | |
| | Ar (parts by volume) | 0 | 1 | 2 | 6 | 10 | 12 |
| Formation of SiC film | He (parts by volume) | 100 | | | | | |
| | TMS (parts by volume) | 0.1 | | | | | |
| Formation of DLC film | He (parts by volume) | 100 | | | | | |
| | TMS (parts by volume) | 0 | | | | | |
| | CH₄ (parts by volume) | 11.4 | | | | | |
| Discharge state | | Glow | Glow | Glow | Glow | Glow | Arc |
| Peeling-off load | | 24 N | 32 N | 32 N | 32 N | 32 N | ··· |

As shown in Table 3, when the mixing amount of an argon gas to 100 parts by volume of helium gas and 1.8 parts by volume of hydrogen gas in the process gas in the pretreatment with a discharge plasma was 1 part by volume or more and 10 parts by volume or less, a glow plasma discharge was maintained and a peeling-off load was good. However, a mixing amount of argon gas falling below this range reduced a peeling-off load, and a mixing amount of argon gas exceeding this range generated an arc discharge.

The film hardness of the DLC film of each of the prototype numbers 2A, 2B, 2C, 2D and 2E was measured, which exceeded 10 GPa.

### (Influence of mixing ratio in pretreatment with discharge plasma: as to mixing amount of hydrogen gas)

Table 4 shows the mixing ratio of component gases in the process gas, a discharge state in the pretreatment with a discharge plasma and a peeling-off load of a DLC film of prototypes 3A, 3B, 3C, 3D, 3E and 3F in which the mixing ratio of component gases was variously changed in the pretreatment with a discharge plasma.

**[Table 4]**

| Prototype No. | | 3A | 3B | 3C | 3D | 3E | 3F |
|---|---|---|---|---|---|---|---|
| Pretreatment with discharge plasma | He (parts by volume) | 100 | | | | | |
| | H₂ (parts by volume) | 0 | 1.0 | 1.8 | 6.0 | 10.0 | 12.0 |
| | Ar (parts by volume) | 2 | | | | | |
| Formation of SiC film | He (parts by volume) | 100 | | | | | |
| | TMS (parts by volume) | 0.1 | | | | | |
| Formation of DLC film | He (parts by volume) | 100 | | | | | |
| | TMS (parts by volume) | 0 | | | | | |
| | CH₄ (parts by volume) | 11.4 | | | | | |
| Discharge state | | Glow | Glow | Glow | Glow | Glow | Arc |
| Peeling-off load | | 24 N | 32 N | 32 N | 32 N | 32 N | ··· |

As shown in Table 4, when the mixing amount of a hydrogen gas to 100 parts by volume of helium gas and 2 parts by volume of argon gas in the process gas in the pretreatment with a discharge plasma was 1.0 part by volume or more and 10.0 parts by volume or less, a glow plasma discharge was maintained and a peeling-off load was good. However, a mixing amount of hydrogen gas falling below this range reduced a peeling-off load, and a mixing amount of hydrogen gas exceeding this range generated an arc discharge.

The film hardness of the DLC film of each of the prototype numbers 3A, 3B, 3C, 3D and 3E was measured, which exceeded 10 GPa.

### (Influence of mixing ratio in formation of DLC film)

Table 5 shows the mixing ratio of component gases in the process gas, a discharge state in the formation of a DLC film and a peeling-off load of a DLC film of prototype numbers 4A, 4B, 4C, 4D, 4E and 4F in which the mixing ratio of component gases was variously changed in the formation of a DLC film.

**[Table 5]**

| Prototype No. | | 4A | 4B | 4C | 4D | 4E | 4F |
|---|---|---|---|---|---|---|---|
| Pretreatment with discharge plasma | He (parts by volume) | 100 | | | | | |
| | H₂ (parts by volume) | 1.8 | | | | | |
| | Ar (parts by volume) | 2 | | | | | |
| Formation of SiC film | He (parts by volume) | 100 | | | | | |
| | TMS (parts by volume) | 0.1 | | | | | |
| Formation of DLC film | He (parts by volume) | 100 | | | | | |
| | TMS (parts by volume) | 0 | 0.5 | 1.0 | 1.5 | 2.0 | 2.5 |
| | CH₄ (parts by volume) | 11.4 | | | | | |
| Discharge state | | Glow | Glow | Glow | Glow | Glow | Unstable |
| Peeling-off load | | 32 N | 48 N | 48 N | 48 N | 48 N | 48 N |

As shown in Table 5, when the mixing amount of a tetramethylsilane gas to 100 parts by volume of helium gas and 11.4 parts by volume of methane gas in the process gas in the formation of a DLC film was 0.5 parts by volume or more and 2 parts by volume or less, a glow plasma discharge was maintained and a peeling-off load was good. However, a mixing amount of tetramethylsilane gas falling below this range reduced a peeling-off load, and a mixing amount of tetramethylsilane gas exceeding this range generated an unstable discharge in which an arc discharge was mixed.

The film hardness of the DLC film of each of the prototype numbers 4A, 4B, 4C, 4D, 4E and 4F was measured, which exceeded 10 GPa.

### <5 Others>

While the invention has been shown and described in detail, the foregoing description is in all aspects illustrative and not restrictive. It is therefore understood that numerous modifications and variations can be devised without departing from the scope of the invention.

## Claims

1. A method of manufacturing a diamond-like carbon film formed body in which a diamond-like carbon film having a film hardness of 10 GPa or more is formed on a surface thereof, the method comprising the steps of:
(a) housing a conductive base inside a chamber;
(b) supplying a first gas mixture containing 100 parts by volume of helium gas and 1 part by volume or more and 10 parts by volume or less of argon gas to the inside of said chamber in which said base is housed while adjusting a pressure inside of said chamber in which said base is housed to 20 hPa or higher and an atmospheric pressure or lower;
(c) generating a discharge plasma in the first gas mixture inside of said chamber in a state in which the pressure inside of said chamber is adjusted to 20 hPa or higher and an atmospheric pressure or lower, and pretreating a surface of said base with the discharge plasma;
(d) forming a silicon carbide film on the surface of said base pretreated with the discharge plasma; and
(e) forming a diamond-like carbon film so as to overlie the silicon carbide film formed on the surface of said base.

2. The method of manufacturing a diamond-like carbon film formed body according to claim 1, wherein said first gas mixture further contains 1 part by volume or more and 10 parts by volume or less of hydrogen gas.

3. The method of manufacturing a diamond-like carbon film formed body according to claim 1 or 2, wherein in said step (c), a DC pulse is repeatedly applied to an electrode pair opposed to each other with said base being sandwiched therebetween to generate a glow plasma discharge in the first gas mixture.

4. The method of manufacturing a diamond-like carbon film formed body according to claim 3, wherein introduced energy by a DC pulse is 1 mJ or more and 10 mJ or less per pulse.

5. The method of manufacturing a diamond-like carbon film formed body according to claim 3, wherein introduced power per unit area obtained by dividing introduced power by a DC pulse by an opposing area of said electrode pair is 50 W/cm² or more.

6. The method of manufacturing a diamond-like carbon film formed body according to claim 1 or 2, further comprising the step of (f) adjusting a temperature of said base to 150°C or higher and 300°C or lower before the surface of said base is pretreated with a discharge plasma.

7. The method of manufacturing a diamond-like carbon film formed body according to claim 1 or 2, wherein said step (d) comprises the steps of:
(d-1) supplying a second gas mixture containing 100 parts by volume of helium gas and 0.1 parts by volume or more and 5 parts by volume or less of tetramethylsilane gas to the inside of said chamber in which the base is housed while adjusting the pressure inside of said chamber in which said base is housed to 20 hPa or higher and an atmospheric pressure or lower; and
(d-2) generating a discharge plasma in the second gas mixture inside of said chamber in a state in which the pressure inside of said chamber is adjusted to 20 hPa or higher and an atmospheric pressure or lower.
